# EUROPÄISCHE PATENTSCHRIFT

(11) **EP 0 529 724 B1**
(45) Veröffentlichungstag und Bekanntmachung des Hinweises auf die Patenterteilung: **24.07.1996**
(21) Anmeldenummer: 92202561.4
(22) Anmeldetag: 21.08.1992
(51) Int. Cl.: H03M 5/14, G11B 20/00, G11B 20/14, H03M 7/46

(54) **Synchronisationsverfahren für einen lauflängenbegrenzten (1,7)-Code und Schaltungsanordnung**
Synchronization method for a run-length limited code (1,7) and circuit arrangement
Méthode de synchronisation pour un code à longueur de série limitée (1,7) et dispositif adapté

(30) Priorität: 23.08.1991 DE 4127984
(43) Veröffentlichungstag der Anmeldung: 03.03.1993
(73) Patentinhaber: BTS BROADCAST TELEVISION SYSTEMS GMBH, D-64347 Griesheim (DE); Philips Electronics N.V., 5621 BA Eindhoven (NL)
(72) Erfinder: Fehlauer, Ewald, W-6108 Weiterstadt (DE); Zirngibl, Wolfram, W-6231 Schwalbach (DE); Lehmann, Jens, W-6086 Riedstadt 1 (DE)
(74) Vertreter: von Laue, Hanns-Ulrich, Dipl.-Ing.

(56) Entgegenhaltungen:
- EP-A- 0 315 295
- DE-A- 3 500 115
- US-A- 4 337 458
- US-A- 4 672 362
- IBM TECHNICAL DISCLOSURE BULLETIN. Bd. 23, Nr. 9, Februar 1981, NEW YORK US Seiten 4375 - 4378 P. A. FRANASZEK 'efficient code for digital magnetic recording'

## Beschreibung

Die Erfindung geht aus von einem Synchronisationsverfahren für einen lauflängen-begrenzten (1,7)-Code nach dem Oberbegriff des Patentanspruchs 1.

(1,7)-Codes werden als Kanalcode bei der magnetischen Aufzeichnung/Wiedergabe von Daten eingesetzt, um die Aufzeichnungsdichte zu erhöhen bzw. die Fehlerrate zu verringern. Aus der Zeitschrift IEEE Transactions on Magnetics, Vol. MAG-12, No.6, November 1976, Seiten 740 bis 742, ist ein derartiger lauflängen-begrenzter (1,7)-Code bekannt, bei welchem jede Eins ("1") von einer folgenden Eins ("1") durch eine bestimmte Anzahl von Nullen ("0") getrennt sein muß. Bei einem (1,7)-Code dürfen minimal eine und maximal sieben Nullen ("0") zwischen folgenden Einsen ("1") auftreten. Die mit Eins ("1") bezeichneten Bits innerhalb einer codierten Bit-Sequenz kennzeichnen dabei die Position von Flußwechseln. Eine Kanal-Codierung der von einem Quell-Coder abgegebenen Daten-Bits in Code-Bits erfolgt so, daß die Daten-Bits in Worten zu zwei Bit unterteilt und in drei Bit-Code-Worte umcodiert werden. Die Code-Rate beträgt somit 2/3.

In dem US-Patent 4,337,458 ist ein Verfahren zur Codierung eines lauflängen-begrenzten (1,7)-Code mit einer Code-Rate von 2/3 angegeben, bei welchem die vier möglichen zwei Bit breiten Daten-Worte mit den Werten 00, 01, 10 und 11 in drei Bit breite Code-Worte umgewandelt werden. Die folgende Tabelle zeigt eine entsprechende Basis-Codierung:

| Daten-Wort | Code-Wort |
|---|---|
| 00 | 101 |
| 01 | 100 |
| 10 | 001 |
| 11 | 010 |

Da diese Basis-Codierung an den Grenzen der Code-Worte auch einen Übergang zwischen zwei "1" mit nur einem Bit Abstand erzeugen würde, tritt für diese Fälle eine Zusatz-Codiervorschrift in Kraft. Die folgende Tabelle zeigt diese entsprechende Zusatz-Codierung:

| Daten-Worte | | kollidierende Code-Worte | | ausgegebene Code-Worte | |
|---|---|---|---|---|---|
| gegenw. | folgende | gegenw. | folgende | gegenw. | folgende |
| 00 | 00 | 101 | 101 | 101 | 000 |
| 00 | 01 | 101 | 100 | 100 | 000 |
| 10 | 00 | 001 | 101 | 001 | 000 |
| 10 | 01 | 001 | 100 | 010 | 000 |

Dieser Kanalcode benutzt demnach nur einen Wortvorrat mit den folgenden fünf Wörtern: 101, 100, 001, 010 und 000. Wegen der Abhängigkeit der Codierung vom nachfolgenden Wort wird dieser Code auch als Look-ahead-Code bezeichnet. Tabellen zur Codierung und Decodierung des (1,7)-Codes sind in der Spalte 4 der US-Patentschrift 4,337,458 angegeben.

Ein anderes Bildungsgesetz zur Codierung und Decodierung eines (1,7)-Codes mit einer Coderate von 2/3 ist aus dem IBM Technical Disclosure Bulletin, Vol. 23, Nr. 9, February 1981, Seiten 4375 bis 4378 bekannt.

Um die auf einem magnetischen Träger aufgezeichnete 3-Bit-Code-Wort-Sequenz wiedergabeseitig in eine 2-Bit-Daten-Wort-Sequenz zurückzuwandeln, müssen zunächst die Wortgrenzen der wiedergegebenen 3-Bit-Code-Worte ermittelt werden. Aus der US-Patentschrift 4,868,690 ist bekannt, ein spezielles Synchronwort in die Folge der aufzuzeichnenden 3-Bit-Code-Worte einzufügen und dieses zusammen mit 3-Bit-Code-Wort-Sequenzen aufzuzeichnen. Im vorliegenden Fall besteht das spezielle Synchronwort aus einer Folge mehrerer Code-Worte mit dem digitalen Wert 010. Auf der Wiedergabeseite wird versucht, die zeitliche Position der eingefügten Synchronwortfolge zu ermitteln, um die Wortgrenzen der wiedergegebenen Codeworte für eine nachfolgende Decodierung zu bestimmen. Die Synchronwort-Erkennung wird mit einem Schieberegister und einem an den Ausgängen des Schieberegisters angeschlossen UND-Gatters durchgeführt. An die Synchronisation der wiedergegebenen Code-Worte werden hohe Anforderungen gestellt, da schon eine Fehlsychronisation um eine Bit-Länge zu einem totalen Datenverlust führt.

Der vorliegenden Erfindung liegt die Aufgabe zugrunde, ein weiteres Synchronisationsverfahren für einen lauflängen-begrenzten (1,7)-Code anzugeben, welches eine eindeutige Synchronisatin der 3-Bit-Code-Worte ermöglicht.

Diese Aufgabe wird durch die im kennzeichnenden Teil des Patentanspruchs 1 angegebenen Merkmale gelöst.

Das erfindungsgemäße Verfahren mit den kennzeichnenden Merkmalen des Patentanspruchs 1 hat den Vorteil, daß im Vergleich zum Stand der Technik die Sicherheit gegen Fehl-Synchronisation erhöht wird.

Durch die in den Unteransprüchen aufgeführten Maßnahmen sind vorteilhafte Weiterbildungen und Verbesserungen des im Patentanspruch 1 angegebenen Verfahrens möglich.

Besonders vorteilhaft ist, daß eine Schaltungsanordnung zur Durchführung des Verfahrens nur einen geringen Schaltungsaufwand aufweist.

Ein Ausführungsbeispiel der Erfindung ist in der Zeichnung dargestellt und in der nachfolgenden Beschreibung näher erläutert. Es zeigen:
- Fig. 1: das Blockschaltbild eines Kanal-Decoders zur Erläuterung des erfindungsgemäßen Synchronisationsverfahrens,
- Fig. 2: ein Zustands-Diagramm des (1,7)-Codes und
- Fig. 3: eine Schaltungsanordnung zur Ableitung eines Synchronisationssignals.

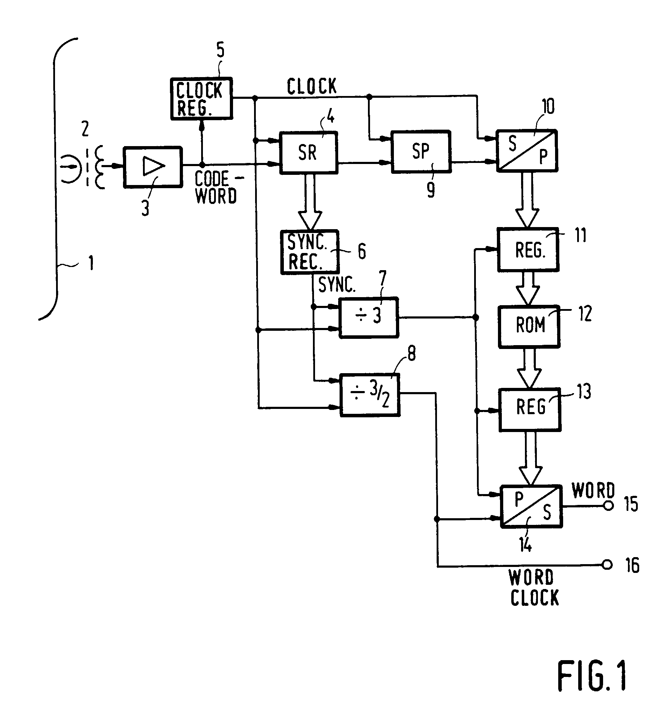

In dem Blockschaltbild der Figur 1 bezeichnet 1 ein Magnetband, von welchem mit einem Wiedergabe-Magnetkopf 2 ein aufgezeichnetes Digitalsignal abgenommen wird. Es sei angenommen, daß das aufgezeichnete Digitalsignal vor der Aufzeichnung einer Kanal-Codierung nach dem in der US-Patentschrift 4, 337,458 angegebenen Verfahren unterworfen sei. Darüber hinaus sei angenommen, daß jeweils die 3-Bit-Code-Worte zu einem Codewortblock zusammengefaßt sind, dem entweder
eine Synchronisationsfolge der Form 0.100.000.001.0 oder
eine Synchronisationsfolge der Form 0.100.000.010.000.001.0
vorangestellt ist. In diesen beiden Synchronisationsfolgen bezeichnen die Punkte Wortgrenzen, die Einsen ("1") einen Flußwechsel und die Nullen ("0") das Fehlen eines Flußwechsels.

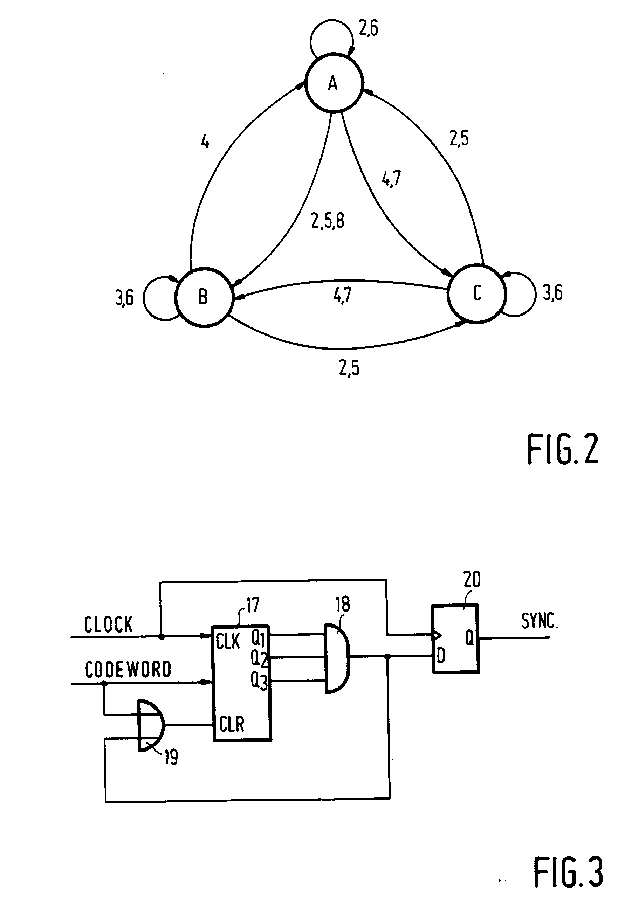

Bei einer Betrachtung eines in der Figur 2 dargestellten Zustands-Diagramms des (1,7)-Codes ist feststellbar, daß die beiden vorgeschlagenen Synchronisationsfolgen eine eindeutige Synchronisation der 3-Bit-Code-Worte erlauben. In dem Zustands-Diagramm bezeichnen A, B und C mögliche Zustände der 3 Bit breiten Code-Worte. Die neben den Zustandsübergängen stehenden Zahlen geben die Anzahl der zwischen zwei Übergängen liegenden Bits an. Einen (1,7)-Code auf diese Weise darzustellen, ist aus der Zeitschrift IEEE Transactions on Communications, Vol. 37, No. 9, September 1989, Seiten 906 bis 917 bekannt. Dem Zustands-Diagramm ist zu entnehmen, daß sowohl nach dem Auftreten einer Synchronisationsfolge mit dem Abstand 8 als auch nach dem direkt hintereinander folgenden zweimaligen Auftreten einer Synchronisationsfolge mit dem Abstand 7 eindeutig der Zustand B erreicht wird. Während jedoch bei einer Folge mit dem Abstand 8 der Zustand A direkt in den Zustand B übergeht, kann der Zustand B bei einer Folge mit dem Abstand 7 erst über den Umweg über Zustand C erreicht werden. Die Eindeutigkeit der Synchronisation ergibt sich aus der Unsymmetrie des vorliegenden Zustands-Diagramms.

Die Wahrscheinlichkeit einer Fehl-Synchronisation ist bei der Nutzung der längeren Synchronisationsfolge geringer als bei der kürzeren Synchronisationsfolge mit dem Abstand 8. Hinsichtlich des Schaltungsaufwands zum Erkennen der beiden Synchronisationsfolgen ist jedoch der kürzeren Synchronisationsfolge dem Vorzug zu geben.

Um die längere Synchronwortfolge zu erzeugen, ist der Zustand vorhergehender und folgender Datenworte zu berücksichtigen. So ergibt beispielsweise eine Bit-Folge mit den folgenden binären

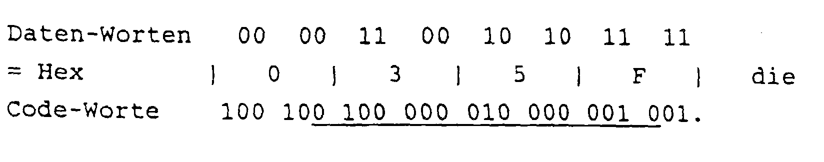

Diese gewählte Bit-Folge der Datenworte entspricht den beiden, im EBU-Standard Tech. 3252-E festgelegten Synchronisationsworten mit dem hexa-dezimalen Wert 30 F5, wobei eine Aufzeichnung der beiden hexa-dezimalen Synchronisationsworte 30 F5 jeweils mit dem niederwertigsten Bit beginnt. Die unterstrichenen Bits der erhaltenen Code-Worte entsprechen dabei in vorteilhafter Weise der vorgeschlagenen längeren Synchronisationsfolge.

Das mit dem Wiedergabemagnetkopf 2 vom Magnetband abgenommene Digitalsignal wird in einer Stufe 3 vorverstärkt und entzerrt. Das so aufbereitete Signal wird dem Eingang eines Schieberegisters 4 und dem Eingang eines Takt-Regenerators 5 zugeführt. In dem als PLL ausgeführten Takt-Regenerator 5 wird der dem aufbereiteten Digitalsignal zugrundeliegende Takt zurückgewonnen. Mit diesem Takt wird das aufbereitete Digitalsignal, welches als 3-Bit-Code-Worte die Daten und die Synchronfolge enthält, seriell in das Schieberegister 4 geschoben. Anschließend wird in einer Stufe 6 das an Bit-parallelen Ausgängen des Schieberegisters 4 vorliegende Datensignal dahingehend überprüft, ob in dem Datenstrom des aufbereiteten Digitalsignals eine dem eingefügten Synchronwort entsprechende Bit-Folge vorliegt. Eine derartige Prüfung kann beispielsweise dadurch erfolgen, daß im Fall der Einfügung der kürzeren Synchronisationsfolge durch Vergleich das Vorliegen von sieben aufeinanderfolgenden Nullen ("0") abgefragt wird.

Eine andere Möglichkeit eine im Datenstrom eingefügte Synchronisationsfolge zu erkennen, besteht darin, das am Ausgang der Stufe 3 abnehmbare serielle Digitalsignal einer Zählschaltung zuzuführen, die die Anzahl von Nullen ("0") zwischen zwei Einsen ("1") zählt. Eine derartige Zählschaltung wird nachfolgend in Verbindung mit der Figur 3 beschrieben.

Beim Erkennen einer bestimmten Synchronisationsfolge im Strom des seriellen Digitalsignals gibt die Stufe 6 einen Synchronisationsimpuls (Sync) ab, der einen 3-Teiler 7 und einen 3/2-Teiler 8 zurücksetzt. An Zähleingängen der Teiler 7 und 8 liegt das von dem Takt-Regenerator 5 erzeugte Taktsignal. An einem Ausgang des 3-Teilers 7 ist ein Code-Wort-Taktsignal und am Ausgang des 3/2-Teilers 8 ein Daten-Wort-Taktsignal abnehmbar.

Neben Bit-parallelen Ausgängen verfügt das Schieberegister 4 auch über einen seriellen Ausgang. Von diesem Ausgang wird das durch das Schieberegister 4 zeitlich verzögerte serielle Digitalsignal über einen Speicher 9 zu einem Serien/Parallel-Wandler 10 weitergeleitet. Das an parallelen Ausgängen des Serien/Parallel-Wandlers 10 abnehmbare Bit-parallelen Digitalsignal wird Code-Wort-Takt-gesteuert in ein Register 11, z.B. ein D-Flipflop, geladen` Der Serien/Parallel-Wandler 10 und das Register 11 ist so ausgelegt, daß das Register 11 Bit-parallele Code-Worte zur Verfügung stellen kann; diese umfassen ein gegenwärtiges Code-Wort, das folgende Code-Wort sowie die letzte Bit-Position des vorangegangenen Code-Wortes. Die derart vorliegenden parallelen Code-Worte werden als Adressen an einen Speicher 12 angelegt, in welchem eine Decodier-Tabelle entsprechend dem eingangs erwähnten US-Patents 4,337,458 abgelegt ist. Die Ausgangsdaten des Speichers 12 sind die decodierten Daten-Worte, die Code-Wort-Takt-gesteuert in einem weiteren Register 13 zwischengespeichert und parallelen Eingängen eines Parallel/Serien-Wandlers 14 zugeleitet werden. An parallelen Eingängen des Parallel/Serien-Wandlers 14 liegenden Daten-Worte werden ebenfalls Code-Wort-Takt-gesteuert von dem Parallel-Serien-Wandler 14 übernommen und anschließend mit 2/3 der Eingangs-Takt-Frequenz serien/parallel-gewandelt und an einer Ausgangsklemme 15 ausgegeben. Parallel zu den seriell ausgegebenen Daten-Worten wird an einer Klemme 16 das zugehörige Taktsignal der Daten-Worte zur Verfügung gestellt.

Durch das Einfügen eines Speichers 9 zwischen der Anordnung zur Synchronworterkennung und der Anordnung zur Decodierung der seriell vorliegenden Code-Worte können auch noch vorhergegangene Daten-Worte bis zur vollen Speichertiefe des Speichers 9 decodiert werden.

Die in der Figur 3 dargestellte Schaltungsanordnung zur Ableitung eines Synchronsignals ist geeignet, das am Ausgang der Stufe 3 abnehmbare Digitalsignal auf Bit-serieller Ebene dahingehend zu untersuchen, ob eine bestimmte Synchronisationsfolge im Digitalsignal vorliegt oder nicht. Dabei wird dem Rücksetzeingang eines Zählers 17 das Bit-serielle Digitalsignal (Code-Wort) und einem Takteingang das von dem Takt-Regenerator erzeugte Taktsignal (Takt) zugeführt. Der Zähler 17 zählt die zwischen zwei Übergängen ("1") vorliegenden Bit-Perioden. Mit einem UND-Gatter 18 wird der Zählerstand des Zählers 17 abgefragt. Je nach gewählter Synchronisationsfolge sind dabei entsprechende Abgriffe des Zählers 17 mit Eingängen des UND-Gatters 18 zu verbinden. Wird in dem anliegenden Bit-seriellen Datenstrom eine entsprechend lange Nullfolge, die kennzeichnend für die gewählte Synchronisationsfolge ist, erkannt, erfolgt über eine ODER-Verknüpfung mit einem ODER-Gatter 19 ein Setzen des Zählers 17. Gleichzeitig wird der am Ausgang des UND-Gatters 18 vorliegende logische Pegel mit dem Takt des Taktsignals (Takt) in einem Register 20 gespeichert, welches das Synchronsignal (Sync) zum Zurücksetzen der Zähler 7 und 8 abgibt.

Die bisher betrachteten Synchronisationsfolgen
0.100.000.001.0 und
0.100.000.010.000.001.0
können auch als Daten in dem natürlichen Datenstrom enthalten sein. Eine sichere Erkennung der im Datenstrom der Code-Worte eingefügten Synchronisationsfolgen bedarf zusätzlicher Maßnahmen. Nach einer Weiterbildung des erfindungsgemäßen Verfahrens kann auf solche zusätzlichen Maßnahmen verzichtet werden, wenn in dem Bit-seriellen Datenstrom eine Synchronisationsfolge eingefügt wird, die mindestens eine Folge gleich polarisierter Bits enthält, die die ursprünglich maximal erlaubte Anzahl um Eins übersteigt. Diese Folge kann zur eindeutigen Synchronisation verwandt werden. Grundsätzlich ist dieses Verfahrens gleichbedeutend mit einer geänderten Abbildungsvorschrift bei der Codierung der Datenworte. Eine solche neue Synchronisationsfolge kann ohne Änderung des Wortvorrates erzeugt werden. Der Unterschied gegenüber der bisherigen Abbildungsvorschrift besteht darin, daß der niederfrequente Signalspektralgehalt im Fall einer erhöhten maximalen Lauflänge vergrößert wird. Diese Änderung kann jedoch durch eine gleichspannungsanteilsfreie Gestaltung der gesamten Synchronisationsfolge begrenzt werden. In dem vorliegenden Ausführungsbeispiel möge die auf einer geänderten Abbildungsvorschrift beruhende Synchronisationsfolge eine Länge von zwei 8-Bit-Datenworten aufweisen, so daß sich folgende Bitfolge ergibt:

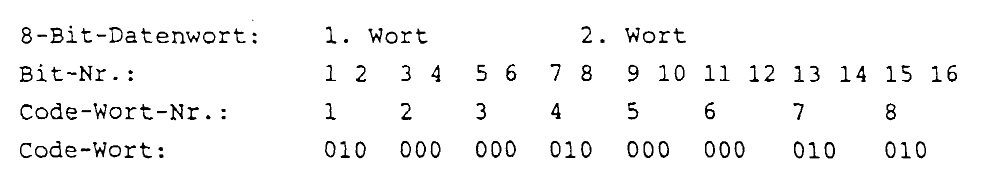

Bei der Codierung dieser Synchronisationsfolge sind aufgrund der Look-ahead-Eigenschaft des (1,7)-Codes Werte von Code-Wörtern, die einem ersten Code-Wort der Synchronisationsfolge vorangehen, sowie Werte von Code-Wörtern, die dem letzten Wort der Synchronisationsfolge folgen, zu berücksichtigen. In den beiden nachfolgenden Tabellen ist dieser Zusammenhang dargestellt.

| Vorgänger | erstes Synchronwort |
|---|---|
| d d d d 0 1 | 0 1 0 |
| 1 0 0 0 0 0 | |

| letztes Synchronwort | Nachfolger |
|---|---|
| 0 1 0 | 1 0 d |
| | 0 0 1 |

Darin bedeutet d = beliebig (don't care). Mit den Vorgänger- und Nachfolger-Codeworten betragen die Lauflängen der Synchronisationsfolge 2 bis 7, 9, 9, 3 und 2 bis 4. Dabei ist festzustellen, daß die an den Grenzen der Synchronisationsfolge entstehenden Lauflängen die Abbildungsvorschrift der Codiertabelle des US-Patent 4,337,458 nicht verletzen. Eine Einfügung dieser Synchronisationsfolge in den seriellen Code-Wort-Strom ist daher ohne Beschränkung möglich. Neben einer erwünschten Gleichspannungsfreiheit weist diese Synchronisationsfolge den Vorteil auf, daß durch die zweifach enthaltene Lauflänge von 9 Bit eine Schaltungsanordnung zur Synchronisations-Erkennung fehlertolerant ausgelegt werden kann.

Diese spezielle Synchronisationsfolge läßt sich nicht nur vorteilhaft zur Code-Wort-Synchronisierung in einem Kanal-Decoder einsetzen sondern auch in einer dem Kanal-Decoder nachgeordneten Signalverarbeitungsschaltung, z.B. einer Schaltung zur Verarbeitung von Signalen nach dem im EBU-Standard Tech. 3252-E festgelegten Vorschriften, wenn coderseitig anstelle von festgelegten Synchronworten (30 F5 ₕₑₓ) entsprechende Daten des Code-Wortes "010 000 000 010 000 000 010 010" in den Datenstrom eingesetzt und decoderseitig auswertet werden. Durch diese Maßnahme wird zum einen eine Synchronwortfolge ausgewerte, die normalerweise nicht im seriellen Datenstrom vorkommt dürfte; zum anderen wird ein 1-Bit-Fehler-tolerantes System geschaffen, bei dem eine der beiden enthaltenen 8-Bit-Nullfolgen durch einen 1-Bit-Fehler gestört sein darf, ohne daß eine Fehl-Synchronisation auftritt.

Wie eingangs dargelegt, kann eine Codier- bzw. Decodier-Tabelle zur Umwandlung der zwei Bit breiten Daten-Worte in 3 Bit breite Code-Worte unter Berücksichtigung der Lauflängen eines (1,7)-Codes auch auf andere Weise angelegt sein. Bei der Anwendung von Codier- und Decodiertabellen nach IBM Technical Disclosure Bulletin, Vol. 23, No. 9. February 1981, Seiten 4375 bis 4378, hat sich die Einfügung einer eindeutigen Synchronfolge in den Codewort-Datenstrom als vorteilhaft erwiesen, welche folgende Bit-Folge aufweist: "000.000.010". Um eine derartige Synchronisationsfolge zu erzeugen, bedarf es eines vorgegebenen Anfangszustandes, der am Beginn einer Datenübertragung zu definieren ist. Dabei ist zu berücksichtigen, daß beginnend von dem Anfangszustand bis zum Zeitpunkt des Einsetzens diese Synchronisationsfolge in den zufälligen Strom der Code-Worte ein beliebiger Zustand vorliegen kann. Es ist also erforderlich, aus einem beliebigen Zustand in einen Zustand σ0 zu gelangen, welcher den Beginn eines in dem IBM Technical Disclosure Bulletin angegebenen Zustand-Diagramms kennzeichnet. Den Datenworten der einzufügenden Synchronisationsfolge kann zu diesem Zweck ein variabler Teil vorangestellt werden, so daß sich folgende Zusammenstellung der zwischen Daten- und Code-Worten in Verbindung mit der Synchronisationsfolge ergibt:

| Daten-Worte vor der Codierung | Code-Worte nach der Codierung |
|---|---|
| σ0 | |
| XXXXXXX00 0101101 XXXXXX | XX1 001 000 000 010 XXX |
| σ1 | |
| XXXXXXX00 0101101 XXXXXX | X1X 101 000 000 010 XXX |
| σ2 | |
| XXXXXXX10 0101101 XXXXXX | 1XX 001 000 000 010 XXX |
| σ3 | |
| XXXXXXX10 0101101 XXXXXX | XXX 001 000 000 010 XXX |
| σ4 | |
| XXXXXXX10 0101101 XXXXXX | XXX 101 000 000 010 XXX |
| σ5 | |
| XXXXXXX10 0101101 XXXXXX | XXX 101 000 000 010 XXX |
| σ6 | |
| XXXXXXX10 0101101 XXXXXX | XXX 101 000 000 010 XXX |

Allgemein läßt die Wortbreite der Code-Worte drei Phasenlage mit gültigen Codeworten zu.
Phasenlage 1: 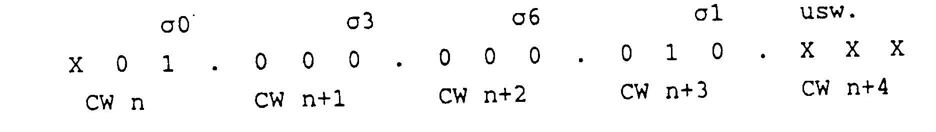
Phasenlage 2: 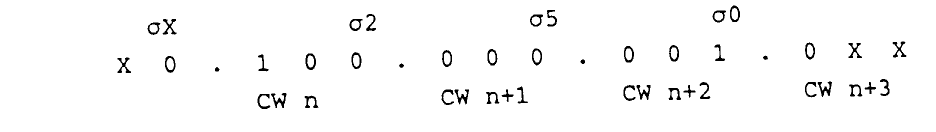
Phasenlage 3:

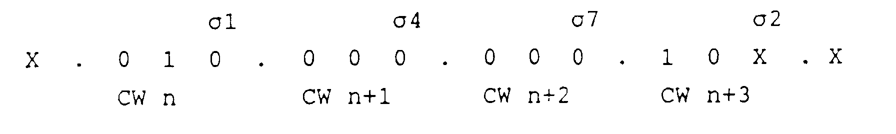

Darin beschreibt beschreibt a die Zustände in einem in dem IBM Technical Disclosure Bulletin angegebenen Zustand-Diagramms und die Punkte Wortgrenzen zwischen den Code-Worten. Da die Folge von Code-Worten nicht beliebig ist und die Wahl eines nächsten Wortes vom Zustand, der durch das vorhergehende Code-Wort festliegt, abhängt, stellt nur die Phasenlage 1 eine wirklich vorkommende und eindeutige Folge zur Synchronisierung des Decoders dar. Bei der angegebenen Phasenlage 2 müßte das Code-Wort 001 in Zustand σ5 definiert sein; in der Phasenlage 3 das Code-Wort 000 in dem Zustand σ4.

## Patentansprüche

1. Synchronisationsverfahren für einen lauflängen-begrenzten (1,7)-Code mit einer Coderate von 2/3,
bei welchem Code Daten-Bits eines seriellen Datenstroms in zwei Bit breite Daten-Worte unterteilt und in drei Bit breite Code-Worte umcodiert werden, wobei eine Folge der drei Bit breiten Code-Worte zwischen benachbarten Einsen (1") mindestens eine Null ("0"), jedoch höchstens sieben Nullen ("0") enthält, und
bei welchem zur phasenrichtigen Decodierung der drei Bit breiten Code-Worte in den Datenstrom der Code-Worte eine bestimmte Synchronisations-Bitfolge eingefügt wird,
**dadurch gekennzeichnet,**
- daß als einzufügende Synchronisations-Bitfolge eine aus mindestens drei aufeinanderfolgenden drei Bit breiten Code-Worten bestehende Synchronisationsfolge erzeugt wird, welche zwischen zwei Einsen ("1") mindestens sechs Nullen ("0") aufweist und
- daß durch Ermittlung der Anzahl der Nullen ("0") zwischen zwei Einsen ("1") die zeitliche Lage der eingefügten Synchronisationsfolge bestimmt wird, um Wortgrenzen seriell übertragener Code-Worte zu erkennen.

2. Synchronisationsverfahren nach Anspruch 1, gekennzeichnet durch eine Synchronisationsfolge mit einer Bit-Sequenz " XX0.100.000.001.0XX ", in welcher die Punkte Wortgrenzen, X einen beliebigen Bit-Wert, "1" einen Signalübergang und "0" keinen Signalübergang darstellt.

3. Synchronisationsverfahren nach Anspruch 1, gekennzeichnet durch eine Synchronisationsfolge mit einer Bit-Sequenz " XX0.100.000.010.000.001.0XX ", in welcher die Punkte Wortgrenzen, X einen beliebigen Bit-Wert, "1" einen Signalübergang und "0" keinen Signalübergang darstellt.

4. Synchronisationsverfahren nach Anspruch 1, gekennzeichnet durch eine Synchronisationsfolge mit einer Bit-Sequenz " XXX.000.000.010.XX ", in welcher die Punkte Wortgrenzen, X einen beliebigen Bit-Wert, "1" einen Signalübergang und "0" keinen Signalübergang darstellt.

5. Synchronisationsverfahren nach Anspruch 1, gekennzeichnet durch eine Synchronisationsfolge mit der Bitsequenz " XXX.010.000.000.010.000.000.010.010.XXX ", in welcher die Punkte Wortgrenzen, X einen beliebigen Bit-Wert, "1" einen Signalübergang und "0" keinen Signalübergang darstellt.

6. Synchronisationsverfahren nach Anspruch 5,
dadurch gekennzeichnet,
daß entspechende Datenworte der Synchronisationsfolge mit der Bitsequenz " XXX.010.000.000.010.000.000.010.010.XXX " anstelle von zur Synchronisierung von Datenblöcken vorgesehenen Synchronisationsworten in einen Datenstrom eingesetzt und übertragen werden und
daß die entsprechenden Datenworte der übertragenen Synchronisationsfolge mit der Bitsequenz " XXX.010.000.000.010.000.000.010.010.XXX " zur Datenblock-Synchronisierung herangezogen wird.

7. Synchronisationsverfahren nach Anspruch 1, dadurch gekennzeichnet, daß die zeitliche Lage der eingefügten Synchronisationsfolge durch Vergleich mit einer vorgegebenen Bitsequenz der Synchronisationsfolge ermittelt wird.

8. Synchronisationsverfahren nach Anspruch 1, dadurch gekennzeichnet, daß die zeitliche Lage der eingefügten Synchronisationsfolge durch Zählen von Nullen zwischen zwei Einsen ermittelt wird und daß aufgrund der zeitlichen Lage der erkannten Synchronisationsfolge eine Zuordnung von Wortgrenzen von im Bit-Strom befindlichen Code-Worten vorgenommen wird.

9. Schaltungsanordnung zur Durchführung des Synchronisationsverfahrens für einen lauflängen-begrenzten (1,7)-Code mit einer Coderate von 2/3 nach Anspruch 1,
bei welchem Code Daten-Bits eines seriellen Datenstroms in zwei Bit breite Daten-Worte unterteilt und in drei Bit breite Code-Worte umcodiert werden, wobei eine Folge der drei Bit breiten Code-Worte zwischen benachbarten Einsen (1") mindestens eine Null ("0"), jedoch höchstens sieben Nullen ("0") enthält, und
bei welchem zur phasenrichtigen Decodierung der drei Bit breiten Code-Worte in den Datenstrom der Code-Worte eine bestimmte Synchronisations-Bitfolge eingefügt wird,
gekennzeichnet durch
eine Einrichtung (4, 6; 17 bis 20) zur Erkennung einer Synchronisationsfolge im Strom von Code-Worten,
einen 3-Teiler (7) zur Frequenzteilung eines den Code-Worten zeitlich zugeordneten Taktsignals, welcher 3-Teiler (7) von einem von der Einrichtung (4, 6; 17 bis 20) zur Erkennung von Synchronisationsfolgen abgeleiteten Synchronsignal zurückgesetzt wird,
einen 3/2-Teiler (8) zur Frequenzteilung des den Code-Worten zeitlich zugeordneten Taktsignals, welcher 3/2-Teiler (8) von dem Synchronsignal der Einrichtung (4, 6; 17 bis 20) zur Erkennung von Synchronisationsfolgen zurückgesetzt wird,
einen Serien/Parallel-Wandler (10) zur Serien/Parallel-Wandlung seriell vorliegender Code-Worte,
ein erstes Register (11) zur Zwischenspeicherung von am Ausgang des Serien/Parallel-Wandlers (10) abnehmbaren, parallelen vorliegenden Code-Worten durch Steuerung eines an einem Ausgang des 3-Teilers (7) abnehmbaren Code-Wort-Taktes,
einen Nur-Lese-Speicher (12) zur Codewandlung der Code-Worte in Daten-Worte,
ein zweites Register (13) zur Zwischenspeicherung der von dem Nur-Lese-Speicher (12) abgegebenen Daten-Worte,
einen Parallel/Serien-Wandler (14), welcher durch Steuerung mit dem Code-Wort-Takt zwischengespeicherte Daten-Worte von einem Ausgang des zweiten Registers (13) übernimmt und durch Steuerung eines am Ausgang des 3/2-Teilers (8) abnehmbaren Daten-Wort-Taktes in Bit-serieller Form ausgibt.

10. Schaltungsanordnung nach Anspruch 9, dadurch gekennzeichnet, daß die Einrichtung (4, 6; 17 bis 20) zur Erkennung von Synchronisationsfolgen ein Schieberegister (4) enthält, in welches seriell Code-Worte geschoben und in paralleler Form an eine Vergleichsanordnung (6) zum Vergleich mit einer bestimmten Synchronisationsfolge ausgegeben werden.

11. Schaltungsanordnung nach Anspruch 9, dadurch gekennzeichnet, daß die Einrichtung (4, 6; 17 bis 20) zum Erkennen einer Synchronisationsfolge einen Zähler (17) aufweist, welcher Takte eines den seriellen Code-Worten zugeordnetes Taktsignal zählt und an Signalübergängen ("1") in den seriellen Code-Worten durch ein Rücksetzsignal eines am Ausgang des Zählers (17) angeschlossenen Decodierers (18) zurücksetzbar ist.

12. Schaltungsanordnung nach Anspruch 11, dadurch gekennzeichnet, daß dem Decodierer (18) ein Register (20) nachgeschaltet ist, welches von Takten eines den seriellen Code-Worten zugeordneten Taktsignal getaktet wird.

13. Schaltungsanordnung nach Anspruch 9, dadurch gekennzeichnet, daß dem Eingang des Serien/Parallel-Wandlers (10) ein Speicher (9) zur zeitlichen Verzögerung der seriellen Code-Worte vorgeschaltet ist.

## Claims

1. A synchronization method for a run length-limited (1.7)-code with a code rate of 2/3,
in which code data bits of a serial data stream are subdivided into two-bit wide data words and transcoded into three-bit wide code words, a sequence of the three-bit wide code words between adjacent ones ("1") comprising at least one zero ("0") but at most seven zeros ("0") and
in which for the decoding of the three-bit wide code words in the correct phase relationship a given synchronization bit sequence is inserted into the data stream of the code words,
characterized in that
- a synchronization sequence comprising at least three consecutive three-bit wide code words is generated as the synchronization bit sequence to be inserted, which sequence has at least six zeros ("0") between two ones ("1"), and
- the temporal position of the inserted synchronization sequence is defined by determining the number of zeros ("0") between two ones ("1") so as to recognize word limits of serially transmitted code words.

2. A synchronization method as claimed in Claim 1, characterized by a synchronization sequence having a bit sequence "XX0.100.000,001.0XX", in which the dots denote word limits, X denotes an arbitrary bit value, "1" denotes a signal transition and "0" denotes no signal transition.

3. A synchronization method as claimed in Claim 1, characterized by a synchronisation sequence having a bit sequence "XX0.100.000.010.000.001.0XX", in which the dots denote word limits, X denotes an arbitrary bit value, "1" denotes a signal transition and "0" denotes no signal transition.

4. A synchronization method as claimed in Claim 1, characterized by a synchronization sequence having a bit sequence "XXX.000.000.010.XX" in which the dots denote word limits, X denotes an arbitrary bit value, "1" denotes a signal transition and "0" denotes no signal transition.

5. A synchronization method as claimed in Claim 1, characterized by a synchronization sequence having the bit sequence "XXX.010.000.000.010.000.000.010.010.XXX", in which the dots denote word limits, X denotes an arbitrary bit value, "1" denotes a signal transition and "0" denotes no signal transition.

6. A synchronization method as claimed in Claim 5, characterized in that
corresponding data words of the synchronization sequence having the bit sequence "XXX.010.000.000.010.000.000.010.010.XXX" are inserted in a data stream and transmitted instead of synchronization words provided for the synchronization of data blocks and
the corresponding data words of the transmitted synchronization sequence having the bit sequence "XXX.010.000.000.010.000.000.010.010.XXX" are used for data block synchronization.

7. A synchronization method as claimed in Claim 1, characterized in that the temporal position of the inserted synchronization sequence is determined by comparison with a predetermined bit sequence of the synchronization sequence.

8. A synchronization method as claimed in Claim 1, characterized in that the temporal position of the inserted synchronization sequence is determined by counting zeros between two ones, and word limits of code words present in the bit stream are allocated on the basis of the temporal position of the recognized synchronization sequence.

9. A circuit arrangement for carrying out the synchronization method for a run length-limited (1.7)-code with a code rate of 2/3 as claimed in Claim 1, in which code data bits of a serial data stream are subdivided into two-bit wide data words and transcoded into three-bit wide code words, a sequence of the three-bit wide code words between adjacent ones ("1") comprising at least one zero ("0") but at most seven zeros ("0") and
in which for the decoding of the three-bit wide code words in the correct phase relationship a given synchronization bit sequence is inserted into the data stream of the code words, characterized by
a device (4, 6; 17 to 20) for recognizing a synchronization sequence in the stream of code words,
a 3-divider (7) for frequency division of a clock signal temporally associated with one of the code words, which 3-divider (7) is reset by a synchronizing signal derived by the device (4, 6; 17 to 20) for recognizing synchronization sequences,
a 3/2-divider (8) for frequency division of the clock signal temporally associated with the code words, which 3/2 divider (8) is reset by the synchronizing signal of the device (4, 6; 17 to 20) for recognizing synchronization sequences,
a series/parallel converter (10) for series/parallel conversion of serial code words,
a first register (11) for buffering parallel code words available at the output of the series/parallel converter (10) under control of a code word clock available at an output of the 3-divider (7),
a read-only memory (12) for code conversion of the code words into data words,
a second register (13) for buffering the data words supplied by the read-only memory (12),
a parallel/series converter (14) which takes over buffered data words from an output of the second register (13) under control of the code word clock and supplies said data words in a bit-serial form under control of a data word clock available at the output of the 3/2-divider (8).

10. A circuit arrangement as claimed in Claim 9, characterized in that the device (4, 6; 17 to 20) for recognizing synchronization sequences comprises a shift register (4), in which code words are serially shifted and supplied in parallel form to a comparison arrangement (6) for comparison with a given synchronization sequence.

11. A circuit arrangement as claimed in Claim 9, characterized in that the device (4, 6; 17 to 20) for recognizing a synchronization sequence comprises a counter (17), which counts clock pulses of a clock signal associated with the serial code words and which can be reset at signal transitions ("1") in the serial code words by means of a reset signal of a decoder (18) connected to the output of the counter (17).

12. A circuit arrangement as claimed in Claim 11, characterized in that the decoder (18) precedes a register (20) which is clocked by clock pulses of a clock signal associated with the serial code words.

13. A circuit arrangement as claimed in Claim 9, characterized in that a memory (9) for time-delaying the serial code words precedes the input of the series/parallel converter (10).

## Revendications

1. Procédé de synchronisation pour un code à longueur de séquence limitée (1,7) présentant un débit de code de 2/3 dans le cas duquel des binaires d'information codés d'un flux d'informations série sont subdivisés en mots d'informations de deux binaires et transcodés en mots de code de trois binaires, une suite des mots de code de trois binaires entre des UNS ("1") voisins contenant au minimum un ZERO ("0"), et au maximum sept ZEROS ("0"), et
dans le cas duquel pour le décodage correct en phase des mots de code de trois binaires, une suite binaire de synchronisation déterminée est insérée dans le flux d'informations des mots de code, caractérisé en ce qu'à titre de suite binaire de synchronisation à insérer, est générée une suite de synchronisation composée d'au moins trois mots de code successifs de trois binaires, cette suite de synchronisation présentant entre deux UNS ("1") au moins six ZEROS ("0") et en ce que la détection du nombre de ZEROS ("0") entre deux UNS ("1") permet de déterminer la position temporelle de la suite de synchronisation insérée, afin de reconnaître les limites de mot des mots de code transmis en série.

2. Procédé de synchronisation suivant la revendication 1, caractérisé par une suite de synchronisation présentant une séquence de binaires "XX0.100.000.001.0XX" dans laquelle les points représentent les limites de mot, X une valeur de binaire quelconque, "1" une transition de signal et "0" l'absence de transition de signal.

3. Procédé de synchronisation suivant la revendication 1, caractérisé par une suite de synchronisation présentant une séquence de binaires "XX0.100.000.010.000.001.0XX" dans laquelle les points représentent les limites de mot, X une valeur de binaire quelconque, "1" une transition de signal et "0" l'absence de transition de signal.

4. Procédé de synchronisation suivant la revendication 1, caractérisé par une suite de synchronisation présentant une séquence de binaires "XXX.000.000.010.XX" dans laquelle les points représentent les limites de mot, X une valeur de binaire quelconque, "1" une transition de signal et "0" l'absence de transition de signal.

5. Procédé de synchronisation suivant la revendication 1, caractérisé par une suite de synchronisation présentant une séquence de binaires "XXX.010,000.000.010.000.000.010.010.XXX" dans laquelle les points représentent les limites de mot, X une valeur de binaire quelconque, "1" une transition de signal et "0" l'absence de transition de signal.

6. Procédé de synchronisation suivant la revendication 5, caractérisé en ce que des mots d'information correspondants de la suite de synchronisation présentant la séquence de binaires "XXX.010.000.000.010.000.000.010.010.XXX" sont insérés et transmis dans un flux d'informations à la place des mots de synchronisation prévus pour la synchronisation des blocs d'informations et en ce que les mots d'information correspondants de la suite de synchronisation transmise présentant la séquence de binaires "XXX.010.000.000.010.000.000.010.010.XXX" sont utilisés pour la synchronisation du bloc d'informations.

7. Procédé de synchronisation suivant la revendication 1, caractérisé en ce que la position temporelle de la suite de synchronisation insérée est détectée par comparaison avec une séquence binaire prédéterminée de la suite de synchronisation.

8. Procédé de synchronisation suivant la revendication 1, caractérisé en ce que la position temporelle de la suite de synchronisation insérée est détectée par comptage des ZEROS entre deux UNS et en ce que, sur la base de la position temporelle de la suite de synchronisation reconnue, des limites de mot sont affectées aux mots de code se trouvant dans le flux binaire.

9. Montage de circuit destiné à l'exécution du procédé de synchronisation pour un code à longueur de séquence limitée (1,7) présentant un débit de code de 2/3 suivant la revendication 1, dans le cas duquel les binaires d'information codés d'un flux d'informations série sont subdivisés en mots d'informations de deux binaires et transcodés en mots de code de trois binaires, une suite des mots de code de trois binaires entre des UNS ("1") voisins contenant au minimum un ZERO ("0"), et, au maximum, sept ZEROS ("0"), et
dans le cas duquel pour le décodage correct en phase des mots de code de trois binaires, une suite binaire de synchronisation déterminée est insérée dans le flux d'informations des mots de code, caractérisé par
un dispositif (4, 6; 17 à 20) de reconnaissance d'une suite de synchronisation dans le flux de mots de code,
un diviseur par 3 (7) destiné à la division de la fréquence d'un signal d'horloge associé temporellement aux mots de code, le diviseur par 3 (7) étant remis à zéro par un signal de synchronisation dérivé du dispositif (4, 6; 17 à 20) de reconnaissance de suites de synchronisation,
un diviseur par 3/2 (8) destiné à la division de la fréquence du signal de cadence associé temporellement aux mots de code, le diviseur par 3/2 (8) étant remis à zéro par le signal de synchronisation du dispositif (4, 6; 17 à 20) de reconnaissance de suites de synchronisation,
un convertisseur série/parallèle (10) pour la conversion série/parallèle de mots de code présents en série,
un premier registre (11) destiné à la mémorisation temporaire de mots de code, présents en parallèle et pouvant être obtenus à la sortie du convertisseur série/parallèle (10), par commande d'un rythme de mot de code pouvant être obtenu à une sortie du diviseur par 3 (7),
une mémoire morte (12) pour le transcodage des mots de code en mots d'information, un second registre (13) destiné à la mémorisation temporaire des mots d'information délivrés par la mémoire morte (12),
un convertisseur parallèle/série (14) qui prend en charge, par commande au rythme de mot de code, des mots d'information mémorisés temporairement à partir d'une sortie du second registre (13) et qui, par commande d'un rythme de mot d'information pouvant être obtenu à la sortie du diviseur par 3/2 (8), produit à sa sortie une série binaire.

10. Montage de circuit suivant la revendication 9, caractérisé en ce que le dispositif (4, 6; 17 à 20) de reconnaissance de suites de synchronisation contient un registre à décalage (4) dans lequel des mots de code série sont décalés et sont présentés sous forme parallèle à un dispositif comparateur (6) destiné à les comparer avec une suite de synchronisation déterminée.

11. Montage de circuit suivant la revendication 9, caractérisé en ce que le dispositif (4, 6; 17 à 20) de reconnaissance d'une suite de synchronisation présente un compteur (17) qui compte les cycles d'un signal de rythme affecté aux mots de code série et qui peut être remis à zéro aux transitions de signal ("1") dans les mots de code série par un signal de remise à zéro d'un décodeur (18) raccordé à la sortie du compteur (17).

12. Montage de circuit suivant la revendication 11, caractérisé en ce que le décodeur (18) est suivi d'un registre (20) qui est synchronisé par les impulsions de rythme d'un signal d'horloge associé aux mots de code série.

13. Montage de circuit suivant la revendication 9, caractérisé en ce que l'entrée du convertisseur série/parallèle (10) est précédée d'une mémoire (9) destinée à retarder temporairement les mots de code série.
